# EUROPÄISCHE PATENTSCHRIFT

(11) **EP 3 252 433 B1**
(45) Veröffentlichungstag und Bekanntmachung des Hinweises auf die Patenterteilung: **09.10.2019**
(21) Anmeldenummer: 17170097.4
(22) Anmeldetag: 09.05.2017
(51) Int. Cl.: G01D 5/241, H03K 17/945

(54) **VORRICHTUNG UND VERFAHREN ZUM ERFASSEN EINER DREHPOSITION EINES DREHBAREN ELEMENTS, STEUERGERÄT, SENSORSYSTEM ZUM ERMITTELN EINER DREHPOSITION EINES DREHBAREN ELEMENTS UND HAUSHALTGERÄT**
DEVICE AND METHOD FOR SENSING A ROTATIONAL POSITION OF A ROTATABLE ELEMENT, CONTROL DEVICE, SENSOR SYSTEM FOR DETERMINING A ROTATIONAL POSITION OF A ROTATABLE ELEMENT AND HOUSEHOLD APPLIANCE
DISPOSITIF ET PROCÉDÉ DE DÉTECTION D'UNE POSITION DE ROTATION D'UN ÉLÉMENT ROTATIF, APPAREIL DE COMMANDE, SYSTÈME DE CAPTEUR DESTINÉ À DÉTERMINER UNE POSITION DE ROTATION D'UN ÉLÉMENT ROTATIF ET APPAREIL MÉNAGER

(30) Priorität: 01.06.2016 DE 102016110085
(43) Veröffentlichungstag der Anmeldung: 06.12.2017
(73) Patentinhaber: Miele & Cie. KG, 33332 Gütersloh (DE)
(72) Erfinder: Exner, Maximilian, 33332 Gütersloh (DE); Evertzberg, Frank, 33428 Marienfeld (DE); Schacht, Florian, 33332 Gütersloh (DE); Banmann, Johann, 33334 Gütersloh (DE)

(56) Entgegenhaltungen:
- EP-A1- 3 002 562
- EP-A1- 3 159 660
- DE-A1- 19 931 809
- DE-A1-102009 002 623
- DE-B4- 4 418 631
- US-A1- 2003 030 570
- US-A1- 2015 198 645

## Beschreibung

Die Erfindung betrifft ein Verfahren zum Bestimmen einer Drehposition eines drehbaren Elements, ein entsprechendes Steuergerät, ein Sensorsystem zum Ermitteln einer Drehposition eines drehbaren Elements und ein Haushaltgerät.

Eine Programmauswahl bzw. Menüführung beispielsweise bei Haushaltgeräten unterschiedlicher Produktgruppen kann insbesondere mittels elektro-mechanischer Drehwahlschalter erfolgen. Es können geräteabhängig inkrementelle oder absolute Auswerteverfahren zum Einsatz kommen. Hierbei kann eine Übertragung einer Drehbewegung von dem Drehwahlschalter beispielsweise durch eine gelagerte Welle auf ein Rastwerk und elektronische Komponenten zur Drehwinkelauswertung auf einer Bedien- und Anzeigeelektronik erfolgen. Eine Auswertung der Drehwinkelposition auf der Bedien- und Anzeigeelektronik kann insbesondere hinter einer Geräteblende erfolgen.

Die DE 10 2009 002 623 A1 offenbart einen Programmwähler für ein Hausgerät mit einer kapazitiven Berührungs- oder Annäherungssensorvorrichtung.

EP 3 002 562 A1 offenbart ein weiteres Verfahren zum Bestimmen einer Drehposition eines drehbaren Elements.

Der Erfindung stellt sich die Aufgabe, ein verbessertes Verfahren zum Bestimmen einer Drehposition eines drehbaren Elements, ein verbessertes Steuergerät, ein verbessertes Sensorsystem zum Ermitteln einer Drehposition eines drehbaren Elements, ein verbessertes Haushaltgerät und ein verbessertes Computer-Programmprodukt bereitzustellen.

Erfindungsgemäß wird diese Aufgabe durch ein Verfahren zum Bestimmen einer Drehposition eines drehbaren Elements, ein entsprechendes Steuergerät, ein Sensorsystem zum Ermitteln einer Drehposition eines drehbaren Elements, ein Haushaltgerät und ein Computer-Programmprodukt mit den Merkmalen der Hauptansprüche gelöst. Vorteilhafte Ausgestaltungen und Weiterbildungen der Erfindung ergeben sich aus den nachfolgenden Unteransprüchen.

Die mit der Erfindung erreichbaren Vorteile bestehen neben einer kostengünstigen und platzsparenden Ausführung insbesondere auch darin, dass eine Messmethode für eine kontaktlose und absolute Drehwinkelbestimmung auf kapazitiver Basis bereitgestellt werden kann. Durch einen Verzicht auf eine Massefläche für einen Stator braucht insbesondere auch kein Draht von einer solchen Massefläche mit Abstand zu Sensorflächen des Stators geführt zu werden, sodass die Bestimmung der Drehposition platzsparend, kostengünstig, unaufwendig und aufgrund der eingesparten Massefläche mit vergrößerter Sensorfläche erfolgen kann. Durch Einsparung der Massefläche können auch keine Störeinflüsse auf einer Zuleitung zu einer solchen Massefläche auftreten. Eine ansonsten für die Massefläche benötigte Fläche kann auf die Sensorflächen verteilt werden, wodurch eine Zunahme einer Fläche jeder der Sensorflächen realisierbar ist, wodurch wiederum ein größerer Rohwert als Messgröße erhalten werden kann. Somit kann nicht nur auf beispielsweise einen Draht, der aufwendig zu einer ansonsten vorgesehenen Massefläche zu führen ist, verzichtet werden, sondern die Drehpositionsbestimmung bzw. Drehwinkelbestimmung kann kapazitiv sowie, insbesondere auch nach einem Neustart bzw. Systemneustart, absolut und zuverlässig erfolgen.

Es wird eine Vorrichtung zum Erfassen einer Drehposition eines drehbaren Elements vorgestellt, wobei die Vorrichtung folgende Merkmale aufweist:
einen Stator mit mehreren bezüglich einer Erstreckungsebene des Stators voneinander getrennter kapazitiver Sensorflächen; und
einen relativ zu dem Stator drehbar platzierbaren oder angeordneten Rotor mit einem elektrisch leitfähigen Leiterabschnitt und einem dielektrischen Nichtleiterabschnitt, wobei der Leiterabschnitt bevorzugt flächenmäßig größer als der Nichtleiterabschnitt ist, der Rotor in einem relativ zu dem Stator drehbar angeordneten Zustand gegenüberliegend der Erstreckungsebene des Stators angeordnet ist, und der Rotor mit dem drehbaren Element koppelbar oder gekoppelt ist.

Dabei kann das drehbare Element ein Bedienelement zum Bedienen zumindest einer Funktion eines Gerätes sein, insbesondere ein Drehwahlschalter. Die Sensorflächen können sich entlang der Erstreckungsebene des Stators erstrecken. Der Nichtleiterabschnitt kann einen dielektrischen Feststoff, einen Spalt, Luftspalt oder eine Lücke aufweisen. Der Leiterabschnitt des Rotors ist ausgebildet, um in einem relativ zu dem Stator drehbar angeordneten Zustand des Rotors zumindest eine Sensorfläche zu bedecken oder zu überlappen. Insbesondere kann der Leiterabschnitt des Rotors in dem relativ zu dem Stator drehbar angeordneten Zustand gegenüberliegend der Erstreckungsebene des Stators angeordnet sein. Der Stator kann mindestens zwei Sensorflächen, mindestens drei Sensorflächen oder mehr als drei Sensorflächen aufweisen.

Bedecken bzw. Überlappen im Sinne der Erfindung ist zu verstehen als eine Anordnung mit einem gegenseitigen Abstand, so dass der Rotor und der Stator sich nicht leitfähig berühren, sondern durch ein Dielektrikum voneinander beabstandet sind, und so, dass die Projektion des Rotors in Richtung senkrecht zu seiner Drehrichtung den Stator zumindest teilweise bedeckt bzw. überlappt. Das Dielektrikum kann Luft, Kunststoff, Glas oder ein anderes geeignetes Material sein.

Die Sensorflächen können bezüglich der Erstreckungsebene des Stators miteinander verzahnt ausgeformt und zusätzlich oder alternativ angeordnet sein. Das bietet den Vorteil, dass die Bestimmung der Drehposition zuverlässig und genau erfolgen kann. Verzahnt im Sinne der Erfindung bedeutet, dass die Trennlinien zwischen Sensorflächen nicht gerade radial vom Mittelpunkt des Stators und/oder Rotors verlaufen, sondern einen beispielsweise wellenartigen, zick-zack-artigen oder anderweitig mäandernden Verlauf aufweisen. Mit anderen Worten, die Sensorflächen greifen an mindestens einer Stelle entlang der Trennlinie in Form einer oder mehrerer Ein- und komplementären Ausbuchtungen ineinander, um den Verlauf der Überdeckung bei einer Drehung des Rotors anzupassen.

Auch kann der Leiterabschnitt des Rotors ausgeformt sein, um mehr als eine Sensorfläche des Stators zu bedecken. Anders ausgedrückt kann der Leiterabschnitt des Rotors ausgeformt sein, um mindestens zwei Sensorflächen des Stators zu bedecken oder zu überlappen. Das bietet den Vorteil, dass eine exakte und sichere Bestimmung der Drehposition ermöglicht wird.

Bevorzugt ist der Leiterabschnitt des Rotors so ausgeformt, dass er mindestens drei Sensorflächen des Stators bedeckt. Dies ist besonders vorteilhaft, da es bei dieser Konstellation eine "mittlere" der drei bedeckten Sensorflächen gibt, die vollständig bedeckt ist, wobei direkt angrenzende Sensorflächen zumindest teilweise bedeckt sind. Das Signal dieser vollständig bedeckten Sensorfläche ändert sich - zumindest über einen gewissen Winkelbereich - im Wesentlichen nicht, wenn der Rotor gedreht wird, da sich dann nur die Bedeckung/das Signal der umliegenden Sensorflächen anteilig ändert, während die Bedeckung der "mittleren" Sensorfläche vollständig bleibt. Dies vereinfacht die Bestimmung der Rotorposition innerhalb dieses Korridors.

Es wird ferner ein Verfahren zum Bestimmen einer Drehposition eines drehbaren Elements vorgestellt, das an einer Vorrichtung angeordnet ist, wobei die Vorrichtung einen Stator mit mehreren bezüglich einer Erstreckungsebene des Stators voneinander getrennten kapazitiven Sensorflächen und einen relativ zu dem Stator drehbar angeordneten Rotor mit einem elektrisch leitfähigen Leiterabschnitt und einem dielektrischen Nichtleiterabschnitt umfasst, wobei der Leiterabschnitt ausgeformt ist, um mindestens zwei, bevorzugt mindestens drei Sensorflächen des Stators zu bedecken und wobei der Rotor in einem relativ zu dem Stator drehbar angeordneten Zustand gegenüberliegend der Erstreckungsebene des Stators angeordnet ist, wobei das Verfahren folgende Schritte aufweist:
Durchführen einer ersten Messreihe, bei der ein elektrisches Messpotenzial an alle Sensorflächen des Stators angelegt wird und - beispielsweise sequenziell, wobei grundsätzlich auch parallel möglich ist - ansprechend auf das Messpotenzial Referenzsignale von den Sensorflächen eingelesen werden, wobei die Referenzsignale von einer Position des Rotors abhängige erste Kapazitätswerte der Sensorflächen repräsentieren;
Ausführen einer zweiten Messreihe, bei der das elektrische Messpotenzial an eine zu messende Sensorfläche der Sensorflächen und ein elektrisches Massepotenzial an alle anderen Sensorflächen angelegt werden, wobei in der zweiten Messreihe sequenziell jede Sensorfläche als zu messende Sensorfläche durchlaufen wird, und ansprechend auf das Messpotenzial und das Massepotenzial Messsignale von den Sensorflächen eingelesen werden, wobei die Messsignale von einer Position des Rotors abhängige zweite Kapazitätswerte der Sensorflächen repräsentieren;
Erzeugen von Nutzsignalen unter Verwendung der Referenzsignale und der Messsignale; und
Verarbeiten der Nutzsignale, um die Drehposition des drehbaren Elements zu bestimmen.

Das Verfahren kann in Verbindung mit bzw. unter Verwendung von einer vorstehend genannten Vorrichtung ausgeführt werden. Das Verfahren kann insbesondere durch ein Steuergerät ausführbar sein. Vorteilhafterweise kann auch ohne ein Berühren bzw. Drehen des drehbaren Elements eine Drehwinkelposition bestimmt werden. Somit kann durch die vorgeschlagene kapazitive Auswertemethode in Kombination mit der Vorrichtung eine sichere Bestimmung einer absoluten Drehwinkelposition auch nach einem Einschalten/Neustarten und ohne Berühren des drehbaren Elements ermöglicht werden. Messreihen sowie Signalverarbeitung können hierbei ausgeführt werden, ohne auf einem Auswerteverfahren basierend auf einer relativen Kapazitätsänderung zu beruhen, bei dem ansprechend auf ein Einschalten/Neustarten Sensorflächen initialisiert würden und deren Kapazität gemessen würde, wobei ohne Drehwinkeländerung oder Berührung des drehbaren Elements auch keine Kapazitätsänderung an den Sensorflächen messbar wäre.

Gemäß einer Ausführungsform kann im Schritt des Erzeugens eine Differenz der Referenzsignale und der Messsignale gebildet werden, um die Nutzsignale zu erzeugen. Eine solche Ausführungsform bietet den Vorteil, dass vergleichbare Sensorsignale erhalten werden können, in denen Störeinflüsse beseitigt sind. Ferner können die Nutzsignale auch bei einem Neustart eines Steuergerätes vergleichbar mit vorherigen Werten sein.

Auch können im Schritt des Verarbeitens die Nutzsignale unter Verwendung zumindest eines Verhältnisses zwischen einem Hochpunkt und einem Tiefpunkt eines Nutzsignals aneinander angeglichen werden. Unter einem Hochpunkt kann ein Maximum und unter einem Tiefpunkt ein Minimum im Signalverlauf verstanden werden. Eine solche Ausführungsform bietet den Vorteil, dass durch ein solches prozentuales Angleichen eine Vergleichbarkeit der Signale miteinander und somit eine Auswertbarkeit verbessert werden kann.

Ferner können im Schritt des Verarbeitens die Nutzsignale normiert und zusätzlich oder alternativ invertiert werden. Eine solche Ausführungsform bietet den Vorteil, dass eine Darstellbarkeit und somit eine Auswertbarkeit der Nutzsignale verbessert werden kann.

Zudem kann im Schritt des Verarbeitens eine Gewichtungsberechnung an den Nutzsignalen durchgeführt werden. Eine solche Ausführungsform bietet den Vorteil, dass die Bestimmung der Drehposition zuverlässig und exakt realisiert werden kann, wobei eine Signalverarbeitung schnell und mit geringem Berechnungsaufwand erfolgen kann.

Dabei kann das Nutzsignal mit dem größten Signalwert als Bezugssignal für die Gewichtungsberechnung berücksichtigt werden. Hierbei kann unter Verwendung einer Position der dem Bezugssignal zugeordneten Sensorfläche ein Korridor für die Drehposition des drehbaren Elements ermittelt werden. Dabei kann unter Verwendung von Nutzsignalen von zu der dem Bezugssignal zugeordneten Sensorfläche benachbarten Sensorflächen die Drehposition des drehbaren Elements innerhalb des ermittelten Korridors bestimmt werden. Auch können hierbei Drehpositionen und zusätzlich oder alternativ Korridore unterschiedlichen (Rast-)Stellungen des drehbaren Elements zugeordnet sein. Eine solche Ausführungsform bietet den Vorteil, dass eine genaue, absolute und sichere Bestimmung der Drehposition bzw. des Drehwinkels ermöglicht wird.

Gemäß einer Ausführungsform können die Schritte des Ausführens einer zweiten Messreihe, des Erzeugen von Nutzsignalen und des Verarbeitens der Nutzsignale wiederholt werden, wobei in dem Schritt des Ausführens der zweiten Messreihe von nur einigen, bevorzugt nur einer der Sensorflächen Messsignale eingelesen werden. Dies kann bevorzugt verwendet werden, um z.B. im ausgeschalteten bzw. Ruhezustand des Haushaltgeräts die vor dem Ausschalten ermittelte letzte Position des Drehwahlschalters, z.B. die AUS-Stellung, zu überwachen, d.h. die eine oder mehreren dieser Stellung zugeordnete(n) Sensorflächen. Erst wenn die AUS-Stellung bzw. der zugeordnete Korridor verlassen wird, wird dann die Überwachung aller Sensorflächen fortgeführt. Dies ermöglicht im AUS-/Ruhezustand des Geräts eine Strom und auch Verarbeitungszeit sparende Überwachung der Position des Drehwahlschalters mit sehr schneller Reaktion im Falle des Einschaltens/Startens des Geräts.

Der hier vorgestellte Ansatz schafft ferner ein Steuergerät, das ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form eines Steuergerätes kann die der Erfindung zugrunde liegende Aufgabe schnell und effizient gelöst werden.

Das Steuergerät kann ausgebildet sein, um Eingangssignale einzulesen und unter Verwendung der Eingangssignale Ausgangssignale zu bestimmen und bereitzustellen. Ein Eingangssignal kann beispielsweise ein über eine Eingangsschnittstelle des Steuergerätes einlesbares Sensorsignal darstellen. Ein Ausgangssignal kann ein Steuersignal oder ein Datensignal darstellen, das an einer Ausgangsschnittstelle des Steuergerätes bereitgestellt werden kann. Das Steuergerät kann ausgebildet sein, um die Ausgangssignale unter Verwendung einer in Hardware oder Software umgesetzten Verarbeitungsvorschrift zu bestimmen. Beispielsweise kann das Steuergerät dazu eine Logikschaltung, einen integrierten Schaltkreis oder ein Softwaremodul umfassen und beispielsweise als ein diskretes Bauelement realisiert sein oder von einem diskreten Bauelement umfasst sein.

Es wird auch ein Sensorsystem zum Ermitteln einer Drehposition eines drehbaren Elements vorgestellt, wobei das Sensorsystem folgende Merkmale aufweist:
eine Ausführungsform der vorstehend genannten Vorrichtung, die einen Stator (250) mit mehreren bezüglich einer Erstreckungsebene des Stators (250) voneinander getrennten kapazitiven Sensorflächen (355) und einen relativ zu dem Stator (250) drehbar angeordneten Rotor (260) mit einem elektrisch leitfähigen Leiterabschnitt (462) und einem dielektrischen Nichtleiterabschnitt (464) umfasst, wobei der Leiterabschnitt (462) ausgeformt ist, um mindestens zwei, bevorzugt mindestens drei Sensorflächen (355) des Stators (250) zu bedecken, wobei der Leiterabschnitt (462) bevorzugt flächenmäßig größer als der Nichtleiterabschnitt (464) ist, und wobei der Rotor (260) in einem relativ zu dem Stator (250) drehbar angeordneten Zustand gegenüberliegend der Erstreckungsebene des Stators (250) angeordnet; und
eine Ausführungsform des vorstehend genannten Steuergerätes, wobei das Steuergerät signalübertragungsfähig mit den Sensorflächen des Stators der Vorrichtung verbindbar oder verbunden ist.

Das drehbare Element kann auf der Blende eines Haushaltgeräts aufgesetzt sein, alternativ kann die Oberseite des drehbaren Elements im Wesentlichen flächenbündig mit der Blendenoberfläche ausgeführt sein, oder weiter alternativ kann das drehbare Element teilweise versenkt in der Blende ausgeführt sein.

Somit können eine Ausführungsform der vorstehend genannten Vorrichtung sowie eine Ausführungsform des vorstehend genannten Steuergerätes bei dem Sensorsystem vorteilhaft zum Ermitteln der Drehposition des drehbaren Elements eingesetzt oder verwendet werden. Bei dem Steuergerät kann es sich um einen Mikrocontroller oder dergleichen handeln.

Es wird zudem ein Haushaltgerät vorgestellt, das folgende Merkmale aufweist:
eine Bedieneinrichtung mit einem drehbarem Element, einer Bedienseite und einer von der Bedienseite abgewandten Geräteseite, wobei das drehbare Element auf der Bedienseite angeordnet ist; und
eine Ausführungsform des vorstehend genannten Sensorsystems, wobei der Rotor der Vorrichtung des Sensorsystems mit dem drehbaren Element der Bedieneinrichtung gekoppelt ist, wobei der Stator der Vorrichtung des Sensorsystems auf der Geräteseite der Bedieneinrichtung angeordnet ist.

Das Haushaltgerät kann insbesondere als ein Gerät zur Wäschebehandlung, beispielsweise eine Waschmaschine, ein Trockner oder dergleichen, zur Lebensmittelbehandlung, beispielsweise eine Mikrowelle, ein Herd oder dergleichen, oder ein ähnliches Gerät, auch für einen gewerblichen oder professionellen Einsatz, ausgeführt sein. Das drehbare Element kann als ein Drehwahlschalter oder dergleichen ausgeführt sein. Das drehbare Element kann zwischen mehreren Raststellungen drehbar sein. Mittels des Sensorsystems können gerade und ungerade Raststellungen detektiert werden, wobei mehr als zweimal so viele Raststellungen wie an dem Stator vorhandene Sensorflächen realisiert sein können. Es kann somit ermöglicht werden, eine beliebige Anzahl an geraden und ungeraden Raststellungen des drehbaren Elements zu erfassen, bei gleichbleibender Anzahl von Sensorflächen. Bei einem Wechsel zwischen zwei Positionen können Sprünge zwischen den Positionen vermieden werden.

Anders ausgedrückt können bei gleichbleibender Zahl an Sensorflächen gerade und ungerade Raststellungen erfasst werden. Hinsichtlich der Sensorflächen können hierbei Störungen, wie etwa durch eine zentriert sitzende Massefläche und deren Zuleitung, verhindert werden und es kann ein Eingang des Steuergerätes eingespart werden. Bei einer Drehbewegung des drehbaren Elements können Sprünge zwischen zwei Positionen vermieden werden. Beispielsweise können auch Zwischenposition detektiert werden. Dies kann nützlich sein, um zu erkennen, ob ein Rastwerk in einer Position hängt. Es ist sogar möglich, einen Drehwahlschalter mit einer hohen Anzahl von erfassbaren Stellungen, d.h. quasi bzw. annähernd stufenlos, bereitzustellen, da die Anzahl der erfassbaren Zwischenpositionen bei mindestens 3 Sensorflächen auf dem Stator im Wesentlichen nur von der möglichen Auflösung der Messung begrenzt wird.

Außerdem kann eine Laufzeit für einen kompletten Mess- und Berechnungszyklus gegenüber bekannten Lösung, beispielsweise der genannten mit einem Massedraht, optimiert oder verkürzt werden.

Jede Sensorfläche auf dem Stator lässt sich seitens des Messverfahrens aktivieren und deaktivieren, somit können einzelne Sensoren für die erste und zweite Messreihe sowie die weitere Berechnung gezielt ein-/ausgeschlossen werden. Es ist möglich, Sensorflächen zu deaktivieren, bis nur noch eine Sensorfläche für das Messverfahren aktiv ist, beispielsweise diejenige mit der größten Überdeckung durch den Rotor. Dadurch reduzieren sich die Messzykluszeit und der Rechenaufwand des Steuergerätes und letztlich auch der Stromverbrauch. Die Reduktion von zu messenden Sensorflächen des Stators kann genutzt werden, um nur noch eine beliebige Position des Drehwahlschalters, in einem Ausführungsbeispiel etwa die "AUS"-Position des betreffenden Haushaltgeräts, zu überwachen. Im Anwendungsfall würde dies bevorzugt im Standby-Betrieb eingesetzt werden, wohingegen im Betriebszustand ("AN") die Erfassung von mehr oder allen Sensorflächen aktiviert werden kann.

Außerdem kann ermöglicht werden, dass das drehbare Element an jeder beliebigen Stelle bzw. Drehposition auf "Null" gesetzt werden kann. Dies hat den Vorteil, dass das drehbare Element beispielsweise in einem Fertigungsprozess in jeder beliebigen Position eingesetzt werden kann. Eine Störanfälligkeit gegenüber EMV-Störgrößen (EMV = elektromagnetische Verträglichkeit) kann durch die Referenzmessung bzw. die erste Messreihe reduziert oder behoben werden. Auf Grund der in Haushaltgeräten bereits teilweise vorhandenen Touch-Controller und günstigen Systemkomponenten kann beispielsweise die vorgestellte kapazitive Drehwinkelbestimmung kostengünstig umgesetzt werden.

Gemäß einer Ausführungsform kann die Bedieneinrichtung einen durchgehend ausgeformten dielektrischen Gehäuseabschnitt aufweisen. Hierbei können zumindest die Vorrichtung des Sensorsystems und das drehbare Element an dem Gehäuseabschnitt angeordnet sein. Der Gehäuseabschnitt kann als eine Bedienblende, Schalterblende, Gehäuseblende oder dergleichen ausgeführt sein, insbesondere aus einem Kunststoffmaterial ausgeformt. Eine solche Ausführungsform bietet den Vorteil, dass die Bestimmung der Drehposition durch die geschlossene Schalterblende realisiert werden kann. Dabei kann ein beschalteter Drehwahlschalter ohne Durchbruch in der Blende aufgebaut werden, indem der Stator hinter der Bedienblende und der Rotor auf der Bedienblende im Drehwahlschalter positioniert werden können. Die Positionsbestimmung kann auf einer kapazitiven Messmethode beruhen und die Positionsbestimmung kann zuverlässig auch direkt nach einem Start des Steuergerätes erfolgen. Somit ist eine Eignung für Haushaltgeräte gegeben, bei denen Drehwahlschalter in einem Bedienkonzept vorgesehen sind. Es braucht abhängig vom Material des Gehäuseabschnitts (Kunststoff, Glas, etc.) lediglich eine Materialstärke berücksichtigt werden. Eine mittels des Sensorsystems erreichbare Auflösung ist insbesondere lediglich begrenzt durch Signalstärken und beispielsweise unabhängig von einer Anzahl an Sensorflächen.

Von Vorteil ist auch ein Computer-Programmprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann. Wird das Programmprodukt oder Programm auf einem Computer oder einem Steuergerät ausgeführt, so kann das Programmprodukt oder Programm zur Durchführung, Umsetzung und/oder Ansteuerung der Schritte des Verfahrens nach einer der vorstehend beschriebenen Ausführungsformen verwendet werden.

Ein Ausführungsbeispiel der Erfindung ist in den Zeichnungen rein schematisch dargestellt und wird nachfolgend näher beschrieben. Es zeigt
- Figur 1: eine schematische Darstellung eines Haushaltgerätes gemäß einem Ausführungsbeispiel der Erfindung;
- Figur 2: eine schematische Darstellung eines Sensorsystems gemäß einem Ausführungsbeispiel der Erfindung;
- Figur 3: eine schematische Darstellung eines Stators einer Vorrichtung gemäß einem Ausführungsbeispiel der Erfindung;
- Figur 4: eine schematische Darstellung eines Rotors einer Vorrichtung gemäß einem Ausführungsbeispiel der Erfindung;
- Figur 5: eine schematische Darstellung von Stator mit überlagertem Rotor in einer Draufsicht gemäß einem Ausführungsbeispiel der Erfindung;
- Figur 6: ein Ablaufdiagramm eines Verfahrens zum Bestimmen gemäß einem Ausführungsbeispiel der Erfindung;
- Figur 7: ein Ablaufdiagramm eines Positionsbestimmungsprozesses gemäß einem Ausführungsbeispiel der Erfindung;
- Figur 8: ein schematisches Signalverlaufsdiagramm gemäß einem Ausführungsbeispiel der Erfindung;
- Figur 9: ein schematisches Signalverlaufsdiagramm gemäß einem Ausführungsbeispiel der Erfindung; und
- Figur 10: ein schematisches Signalverlaufsdiagramm gemäß einem Ausführungsbeispiel der Erfindung.

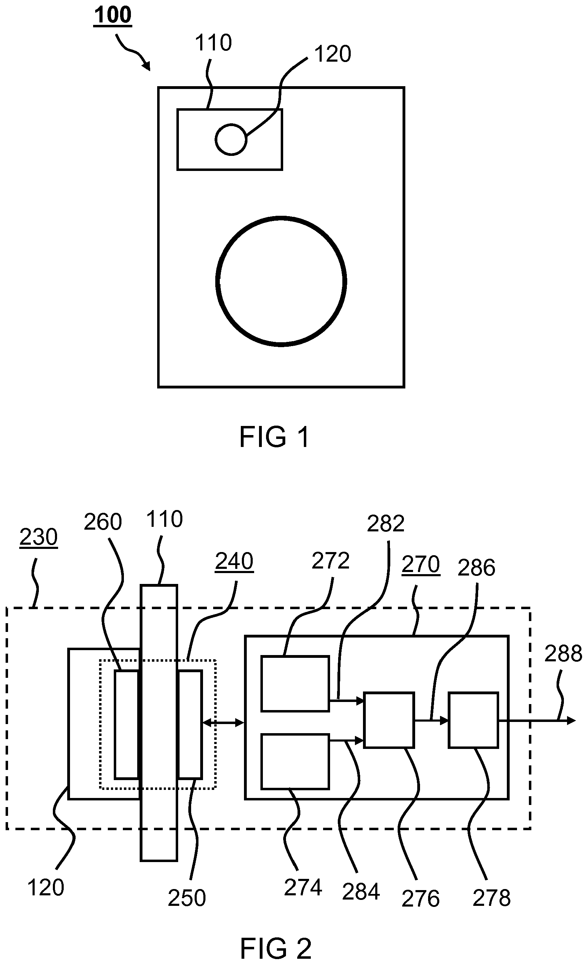

Figur 1 zeigt eine schematische Darstellung eines Haushaltgerätes 100 gemäß einem Ausführungsbeispiel der Erfindung. Das Haushaltgerät 100 ist hierbei lediglich beispielhaft als eine Waschmaschine, ein Wäschetrockner oder ein Kombigerät aus Waschmaschine und Wäschetrockner ausgeführt. Das Haushaltgerät 100 weist eine Bedieneinrichtung 110 mit einem drehbaren Element 120 auf.

In Figur 1 ist darstellungsbedingt lediglich eine Bedienseite der Bedieneinrichtung 110 gezeigt. Die Bedienseite der Bedieneinrichtung 110 ist hierbei einer Bedienperson des Haushaltgerätes 100 zugewandt bzw. von einem Innenraum des Haushaltgerätes 100 abgewandt. Die Bedieneinrichtung 110 weist auch eine von der Bedienseite abgewandte bzw. dem Innenraum des Haushaltgerätes 100 zugewandte Geräteseite auf. Das drehbare Element 120 ist an der Bedienseite der Bedieneinrichtung 110 angeordnet. Bei dem drehbaren Element 120 handelt es sich beispielsweise um einen Drehwahlschalter. Das drehbare Element 120 ist relativ zu der Bedieneinrichtung 110 drehbar angeordnet.

Das Haushaltgerät 100 weist auch ein Sensorsystem auf, welches darstellungsbedingt in Figur 1 verdeckt ist. Auf das Sensorsystem wird in Zusammenhang mit der Bedieneinrichtung 110 und dem drehbaren Element 120 nachfolgend noch detaillierter eingegangen.

Figur 2 zeigt eine schematische Darstellung eines Sensorsystems 230 gemäß einem Ausführungsbeispiel der Erfindung. Das Sensorsystem 230 ist hierbei an der Bedieneinrichtung 110 und dem drehbaren Element 120 des Haushaltgerätes aus Figur 1 angeordnet. Alternativ kann das Sensorsystem 230 an einer Bedieneinrichtung und einem drehbaren Element eines ähnlichen Haushaltgerätes angeordnet sein. Somit sind in Figur 2 die Bedieneinrichtung 110, das drehbare Element 120 und das Sensorsystem 230 gezeigt.

Das Sensorsystem 230 ist ausgebildet, um eine Drehposition des drehbaren Elements 120 zu ermitteln. Das Sensorsystem 230 weist eine Vorrichtung 240 zum Erfassen der Drehposition des drehbaren Elements 120 bzw. eine Erfassungsvorrichtung 240 und ein Steuergerät 270 zum Bestimmen der Drehposition des drehbaren Elements 120 auf.

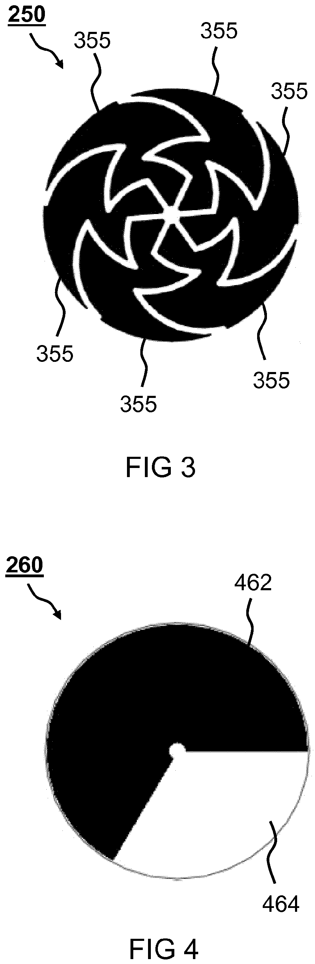

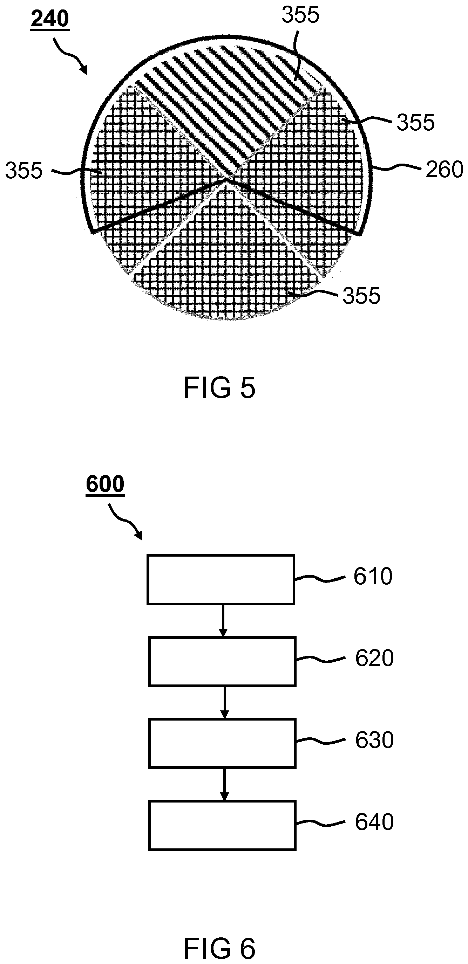

Die Erfassungsvorrichtung 240 weist einen Stator 250 und einen Rotor 260 auf. Unter dem Stator 250 können positionsfest angeordnete Sensorflächen verstanden werden, die mit dem Steuergerät 270 bzw. Mikrocontroller elektrisch verbunden sind. Der Stator 250 weist mehrere bezüglich einer Erstreckungsebene des Stators 250 voneinander getrennter kapazitiver Sensorflächen auf. Der Stator 250 wird nachfolgend unter Bezugnahme auf Figur 3 bzw. Figur 5 detaillierter erläutert. Der Rotor 260 ist relativ zu dem Stator 250 drehbar angeordnet. Der Rotor 260 weist einen elektrisch leitfähigen Leiterabschnitt und einem dielektrischen Nichtleiterabschnitt auf. Auch wenn es in Figur 2 darstellungsbedingt nicht explizit gezeigt ist, so ist der Leiterabschnitt flächenmäßig größer als der Nichtleiterabschnitt des Rotors 260. Der Rotor 260 weist anders ausgedrückt eine runde Kupferfläche, bei der ein bestimmter Winkel ausgespart ist, bzw. ein Kreissegment als Leiterabschnitt auf. Der Rotor ist drehbar über dem Stator gelagert, dazwischen befindet sich ein Dielektrikum.

Auf den Rotor 260 wird nachfolgend unter Bezugnahme auf Figur 4 bzw. Figur 5 noch näher eingegangen.

Der Rotor 260 ist gegenüberliegend der Erstreckungsebene des Stators angeordnet. Auch ist der Rotor 260 mit dem drehbaren Element 120 gekoppelt. Anders ausgedrückt weist das drehbare Element 120 den Rotor 260 auf. Der Stator 250 der Erfassungsvorrichtung 240 ist auf der Geräteseite der Bedieneinrichtung 110 angeordnet, wobei der Rotor 260, wie auch das drehbare Element 120, auf der Bedienseite der Bedieneinrichtung 110 angeordnet ist.

Die Bedieneinrichtung 110 weist gemäß dem in Figur 2 dargestellten Ausführungsbeispiel der Erfindung einen durchgehend ausgeformten dielektrischen Gehäuseabschnitt auf bzw. ist als ein durchgehender, dielektrischer Gehäuseabschnitt ausgeformt. Anders ausgedrückt ist der Gehäuseabschnitt frei von Durchgangsöffnungen. Hierbei sind die Erfassungsvorrichtung 240 und das drehbare Element 120 an dem Gehäuseabschnitt der Bedieneinrichtung 110 angeordnet.

Das Steuergerät 270 ist signalübertragungsfähig mit den Sensorflächen des Stators 250 der Erfassungsvorrichtung 240 verbunden, wie es symbolisch durch einen Doppelpfeil in Figur 2 dargestellt ist. Bei dem Steuergerät 270 handelt es sich beispielsweise um einen Mikrocontroller. Alternativ ist das Steuergerät 270 als Teil eines Mikrocontrollers ausgeführt. Das Steuergerät 270 weist eine Durchführungseinrichtung 272, eine Ausführungseinrichtung 274, eine Erzeugungseinrichtung 276 und eine Verarbeitungseinrichtung 278 auf.

Die Durchführungseinrichtung 272 ist ausgebildet, um eine erste Messreihe durchzuführen. Hierbei ist die Durchführungseinrichtung 272 ausgebildet, um ein elektrisches Messpotenzial an alle Sensorflächen des Stators anzulegen und um - beispielsweise sequenziell, wobei grundsätzlich auch parallel möglich ist - ansprechend auf das angelegte Messpotenzial Referenzsignale 282 von den Sensorflächen einzulesen. Ferner ist die Durchführungseinrichtung 272 ausgebildet, um die Referenzsignale 282 an die Erzeugungseinrichtung 276 auszugeben oder für die Versorgungseinrichtung 276 bereitzustellen. Die Referenzsignale 282 repräsentieren von einer Position des Rotors 260 abhängige erste Kapazitätswerte der Sensorflächen des Stators 250.

Die Ausführungseinrichtung 274 ist ausgebildet, um eine zweite Messreihe auszuführen. Dabei ist die Ausführungseinrichtung 274 ausgebildet, um das elektrische Messpotenzial an eine zu messende Sensorfläche der Sensorflächen und ein elektrisches Massepotenzial an alle anderen Sensorflächen anzulegen, für die zweite Messreihe sequenziell jede Sensorfläche als zu messende Sensorfläche zu durchlaufen und ansprechend auf das Messpotenzial und das Massepotenzial Messsignale 284 von den Sensorflächen einzulesen. Auch ist die Ausführungseinrichtung 274 ausgebildet, um die Messsignale 284 an die Erzeugungseinrichtung 276 auszugeben oder für die Versorgungseinrichtung 276 bereitzustellen. Die Messsignale 284 repräsentieren von einer Position des Rotors 260 abhängige zweite Kapazitätswerte der Sensorflächen des Stators 250.

Die Erzeugungseinrichtung 276 ist ausgebildet, um die Referenzsignale 282 und die Messsignale 284 einzulesen. Ferner ist die Erzeugungseinrichtung 276 ausgebildet, um unter Verwendung der Referenzsignale 282 und der Messsignale 284 dann Nutzsignale 286 zu erzeugen. Die Erzeugungseinrichtung 276 ist auch ausgebildet, um die Nutzsignale 286 an die Verarbeitungseinrichtung 278 auszugeben oder für die Verarbeitungseinrichtung 278 bereitzustellen.

Die Verarbeitungseinrichtung 278 ist ausgebildet, um die Nutzsignale 286 einzulesen oder zu empfangen und zu verarbeiten, um die Drehposition des drehbaren Elements 120 zu bestimmen. Ferner ist die Verarbeitungseinrichtung 278 ausgebildet, um ein Positionssignal 288 bereitzustellen, dass die bestimmte Drehposition des drehbaren Elements 120 repräsentiert. Anders ausgedrückt ist die Verarbeitungseinrichtung 278 ausgebildet, um die Nutzsignale 286 einzulesen und unter Verwendung der Nutzsignale 286 das Positionssignal 288 zu erzeugen.

Das Messpotenzial kann auch als ein sogenanntes Shield-Potenzial bezeichnet werden. Auf Shield geschaltete Sensorflächen bzw. Sensoren werden mit einem Abbild der zu messenden bzw. gescannten Sensorfläche aufgeladen. Eine Potenzialdifferenz zwischen der zu messenden Sensorfläche und einer auf Shield geschalteten Sensorfläche ist Null. Das Massepotenzial kann auch als ein sogenanntes Ground-Potenzial bezeichnet werden. Auf Ground geschaltete Sensorflächen werden direkt mit dem Massepotenzial verbunden. Es ist eine Potenzialdifferenz zwischen der zu messenden Sensorfläche einer und der auf Ground geschalteten Sensorfläche festzustellen.

Figur 3 zeigt eine schematische Darstellung eines Stators 250 einer Vorrichtung bzw. Erfassungsvorrichtung gemäß einem Ausführungsbeispiel der Erfindung. Bei dem Stator 250 handelt es sich beispielsweise um den Stator aus Figur 2 oder einen ähnlichen Stator. In der Ansicht von Figur 3 sind die bezüglich der Erstreckungsebene des Stators 250 voneinander getrennten kapazitiven Sensorflächen 355 dargestellt. Der Stator 250 weist lediglich beispielhaft sechs Sensorflächen 355 auf. Die Sensorflächen 355 des Stators 250 sind gemäß dem hier dargestellten Ausführungsbeispiel der Erfindung bezüglich der Erstreckungsebene des Stators 250 miteinander verzahnt ausgeformt und/oder angeordnet. Anders ausgedrückt weisen Zwischenräume zwischen den Sensorflächen 355 hierbei einen gewinkelten oder gezackten Verlauf auf. Die Erstreckungsebene des Stators 250 entspricht hierbei einer Zeichenebene von Figur 3.

Figur 4 zeigt eine schematische Darstellung eines Rotors 260 einer Vorrichtung bzw. Erfassungsvorrichtung gemäß einem Ausführungsbeispiel der Erfindung. Bei dem Rotor 260 handelt es sich beispielsweise um den Rotor aus Figur 2 oder einen ähnlichen Rotor. In der Darstellung von Figur 4 sind der elektrisch leitfähige Leiterabschnitt 462 und der dielektrische Nichtleiterabschnitt 464 des Rotors 260 gezeigt. Hierbei ist auch erkennbar, dass der Leiterabschnitt 462 flächenmäßig größer ist als der Nichtleiterabschnitt 464.

Figur 5 zeigt eine schematische Darstellung einer Vorrichtung 240 bzw. Erfassungsvorrichtung 240 gemäß einem Ausführungsbeispiel der Erfindung. Hierbei entspricht oder ähnelt die Erfassungsvorrichtung 240 der Erfassungsvorrichtung aus Figur 2. Der Rotor 260 der Erfassungsvorrichtung 240 entspricht oder ähnelt hierbei dem Rotor aus Figur 4, wobei in Figur 5 zu Veranschaulichungszwecken lediglich der Leiterabschnitt des Rotors 260 eingezeichnet ist. Der Rotor 260 kann auch als ein invertierter Rotor 260 bezeichnet werden. Der Stator der Erfassungsvorrichtung 240 ähnelt dem Stator aus Figur 3 bzw. entspricht dem Stator aus Figur 3 mit Ausnahme dessen, dass von dem Stator in der Darstellung von Figur 5 zu Veranschaulichungszwecken lediglich beispielhaft vier Sensorflächen 355 gezeigt sind, die hierbei unverzahnt ausgeführt sind.

In Figur 5 ist erkennbar, dass der Leiterabschnitt des Rotors 260 ausgeformt ist, um mehr als eine Sensorfläche 355 des Stators zu bedecken. Gemäß dem in Figur 5 dargestellten Ausführungsbeispiel der Erfindung ist der Leiterabschnitt des Rotors 260 ausgeformt ist, um mehr als zwei Sensorflächen 355 des Stators zu bedecken. Ferner ist in Figur 5 durch einfache Schraffur eine momentan zu messende Sensorfläche 355 veranschaulicht, wobei durch Kreuzschraffur bezüglich der zu messenden Sensorfläche 355 umliegende Sensorflächen 355 kenntlich gemacht sind.

Figur 5 zeigt eine Darstellung hinsichtlich eines Messprinzips, wobei alle Sensorflächen 355 sequenziell oder periodisch auf ihre Kapazität gemessen werden. Unter einer bedeckten Sensorfläche 355 versteht man eine Sensorfläche 355 des Stators, die von der Kupferfläche bzw. dem Leiterabschnitt des Rotors 260 bedeckt ist. Unter einer unbedeckten Sensorfläche 355 versteht man eine Sensorfläche 355 des Stators, die von einer Freifläche bzw. dem Nichtleiterabschnitt des Rotors 260 bedeckt ist bzw. von der Kupferfläche unbedeckt ist. Unter einer zu messenden bzw. gescannten Sensorfläche 355 versteht man eine Sensorfläche 355 des Stators, die zu diesem Zeitpunkt von dem Steuergerät bzw. Mikrocontroller gemessen bzw. gescannt wird. Bei einem gesamten Scan-Vorgang wird jede Sensorfläche 355 sequenziell bzw. nach und nach gemessen. Bei einer solchen Messung ist festzustellen, ob eine Sensorfläche 355 durch den Rotor 260 bedeckt oder unbedeckt ist. Hierbei wird eine bedeckte Sensorfläche 355 als inaktiv bezeichnet, wobei eine unbedeckte Sensorfläche 355 als aktiv bezeichnet wird. In der der Momentaufnahme von Figur Ziffer fünf würde durch Messung festgestellt, dass die zu messende bzw. gescannte Sensorfläche durch den Rotor 260 bedeckt, also inaktiv, ist. Bei der sequenziellen oder periodischen Kapazitätsmessung aller Sensorflächen 355 bedeutet ein hohes Kapazitäts-Delta eine bedeckte und somit inaktive Sensorfläche 355 und bedeutet ein niedriges Kapazitäts-Delta eine unbedeckte und somit aktive Sensorfläche 355.

Figur 6 zeigt ein Ablaufdiagramm eines Verfahrens 600 zum Bestimmen gemäß einem Ausführungsbeispiel der Erfindung. Das Verfahren 600 zum Bestimmen ist ausführbar, um eine Drehposition eines drehbaren Elements zu bestimmen. Dabei ist das drehbare Element mit dem Rotor der Vorrichtung aus Figur 2 bzw. Figur 5 oder einer ähnlichen Vorrichtung gekoppelt. Somit ist das Verfahren 600 zum Bestimmen in Verbindung mit der Vorrichtung aus Figur 2 bzw. Figur 5 oder einer ähnlichen Vorrichtung ausführbar. Ferner ist das Verfahren 600 zum Bestimmen mittels bzw. unter Verwendung des Steuergerätes aus Figur 2 oder eines ähnlichen Steuergerätes ausführbar.

Das Verfahren 600 zum Bestimmen weist einen Schritt 610 des Durchführens einer ersten Messreihe auf. Dabei wird ein elektrisches Messpotenzial an alle Sensorflächen des Stators angelegt. Ferner werden hierbei ansprechend auf das angelegte Messpotenzial Referenzsignale von den Sensorflächen des Stators der Vorrichtung eingelesen. Die Referenzsignale repräsentieren von einer Position des Rotors abhängige erste Kapazitätswerte der Sensorflächen.

Auch weist das Verfahren 600 zum Bestimmen einen Schritt 620 des Ausführens einer zweiten Messreihe auf. Hierbei wird das elektrische Messpotenzial an eine zu messende Sensorfläche der Sensorflächen angelegt und wird ein elektrisches Massepotenzial an alle anderen Sensorflächen angelegt angelegt. Dabei wird im Schritt 620 des Ausführens bei der zweiten Messreihe sequenziell jede Sensorfläche als zu messende Sensorfläche durchlaufen. Nachfolgend werden hierbei ansprechend auf das angelegte Messpotenzial und das angelegte Massepotenzial Messsignale von den Sensorflächen eingelesen. Die Messsignale repräsentieren von einer Position des Rotors abhängige zweite Kapazitätswerte der Sensorflächen.

Nach dem Schritt 610 des Durchführens der ersten Messreihe und dem Schritt 620 des Ausführens der zweiten Messreihe werden unter Verwendung der Referenzsignale und der Messsignale in einem Schritt 630 des Erzeugens bei dem Verfahren 600 Nutzsignale erzeugt. Nachfolgend werden bei dem Verfahren 600 in einem Schritt 640 des Verarbeitens die Nutzsignale verarbeitet, um die Drehposition des drehbaren Elements zu bestimmen.

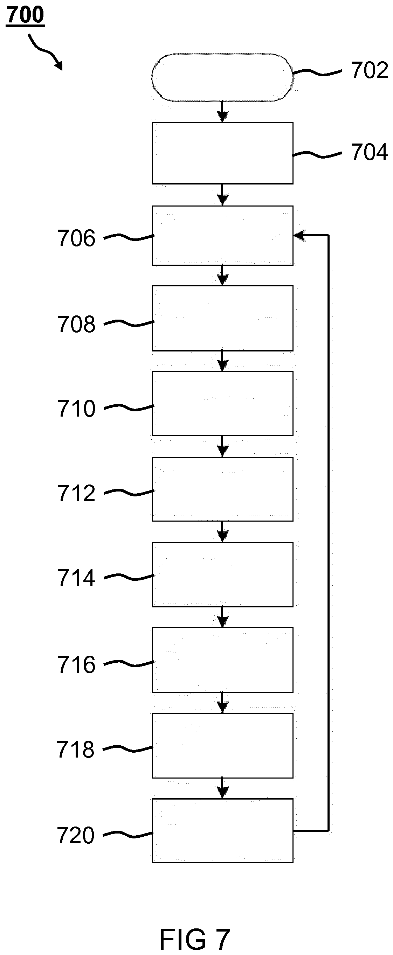

Figur 7 zeigt ein Ablaufdiagramm eines Positionsbestimmungsprozesses 700 gemäß einem Ausführungsbeispiel der Erfindung. Anders ausgedrückt zeigt Figur 7 einen Programmablauf des Positionsbestimmungsprozesses 700. Der Positionsbestimmungsprozess 700 ist in Zusammenhang mit dem Verfahren zum Bestimmen aus Figur 6 oder einem ähnlichen Verfahren sowie in Verbindung mit dem Sensorsystem aus Figur 2 oder einem ähnlichen Sensorsystem ausführbar.

Bei einem Block 702 erfolgt ein Start des Positionsbestimmungsprozesses 700. Danach erfolgt bei einem Block 704 eine Initialisierung. Nachfolgend werden bei einem Block 706 alle Sensorflächen auf Shield bzw. das Messpotenzial gesetzt. Danach werden bei einem Block 708 alle Sensoren bzw. Sensorflächen gescannt. In einem Block 710 wird danach eine Grundlinie bzw. Baseline auf einen gemessenen Rohzählwert bzw. sogenannten Raw-Count gesetzt. Danach werden in einem Block 712 alle Sensorflächen auf Ground (GND) bzw. das Massepotenzial gesetzt. Darauf folgend werden in einem Block 714 alle Sensoren bzw. Sensorflächen gescannt. In einem Block 716 werden dann die Nutzsignale bzw. Signale angeglichen und es wird eine eigene Baseline ermittelt. Danach wird in einem Block 718 das Nutzsignal bzw. Signal invertiert und normiert bzw. angeglichen. Schließlich wird in einem Block 720 eine Signalauswertung mittels Gewichtungsberechnung durchgeführt. Nach der Signalauswertung kann der Programmablauf des Positionsbestimmungsprozesses 700 zurück zu dem Block 706 springen.

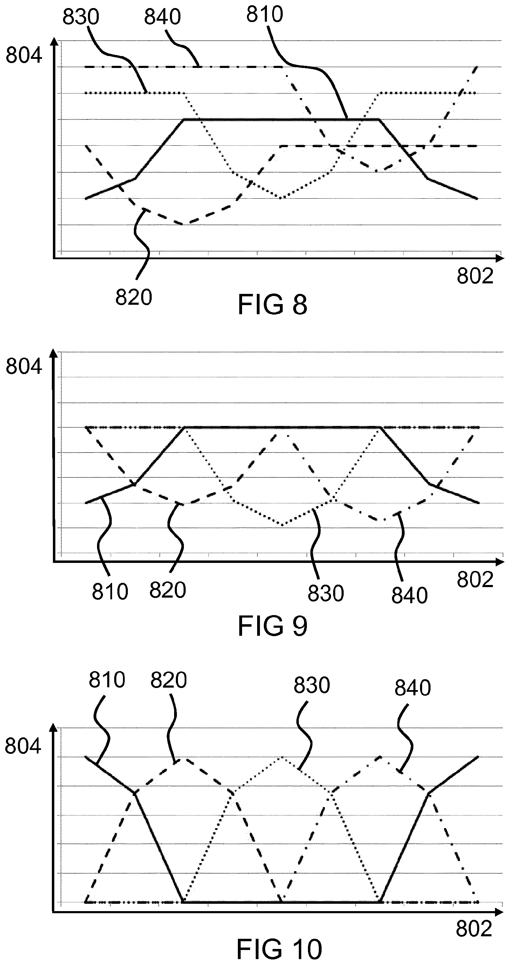

Figur 8 zeigt ein schematisches Signalverlaufsdiagramm gemäß einem Ausführungsbeispiel der Erfindung. Das Signalverlaufsdiagramm ist in Verbindung mit dem Sensorsystem aus Figur 2 oder einem ähnlichen Sensorsystem und/oder in Zusammenhang mit dem Verfahren zum Bestimmen aus Figur 6 oder einem ähnlichen Verfahren zu betrachten, insbesondere in Verbindung mit der Verarbeitungseinrichtung des Steuergerätes des Sensorsystems.

An einer Abszissenachse 802 des Signalverlaufsdiagramms ist ein Drehwinkel des drehbaren Elements bzw. des Rotors relativ zu dem Stator der Erfassungsvorrichtung des Sensorsystems von 0 bis 360 Grad aufgetragen. An einer Ordinatenachse 804 des Signalverlaufsdiagramms sind Signalwerte aufgetragen. In dem Signalverlaufsdiagramm sind Verläufe von beispielhaft lediglich vier erfassten bzw. erzeugten Nutzsignalen 810, 820, 830 und 840 in Abhängigkeit von dem Drehwinkel eingezeichnet.

Figur 9 zeigt ein schematisches Signalverlaufsdiagramm gemäß einem Ausführungsbeispiel der Erfindung. Hierbei entspricht das in Figur 9 dargestellte Signalverlaufsdiagramm dem Signalverlaufsdiagramm aus Figur 8 mit Ausnahme dessen, dass in Figur 9 die Nutzsignale 810, 820, 830 und 840 in einem angeglichenen Zustand gezeigt sind.

Figur 10 zeigt ein schematisches Signalverlaufsdiagramm gemäß einem Ausführungsbeispiel der Erfindung. Hierbei entspricht das in Figur 10 dargestellte Signalverlaufsdiagramm dem Signalverlaufsdiagramm aus Figur 9 mit Ausnahme dessen, dass in Figur 10 die Nutzsignale 810, 820, 830 und 840 zusätzlich in einem normierten und invertierten Zustand gezeigt sind.

Unter Bezugnahme auf die Figuren 1 bis 10 werden nachfolgend Ausführungsbeispiele der vorliegenden Erfindung zusammenfassend und/oder nochmals mit anderen Worten erläutert. Wichtige Aspekte von Ausführungsbeispielen sind eine Geometrie des Rotors 260 und des Stators 250 sowie ein Ablauf des Verfahrens 600 hinsichtlich Messung und Auswertung von Kapazitäten.

Eine für eine solche Messung benötigte Potenzialdifferenz wird über den Rotor 260 bzw. dessen Leiterabschnitt 462 eingekoppelt. Dieser koppelt die Potenzialdifferenz über die benachbarten Sensorflächen 355 einer gemessenen Sensorfläche 355 ein, wie es in Figur 5 gezeigt ist. Dazu können die Sensorflächen 355, beispielsweise in einer Software des Steuergerätes 270 bzw. Mikrocontrollers, für den ungescannten Zustand konfiguriert werden. Bei einem solchen Messverfahren ist ein Rotor 260 mit einem Leiterabschnitt 462 bzw. einer elektrisch leitenden Fläche von mindestens zwei Sensorflächen 355 vorgesehen. Somit erfährt ein Nutzsignal 286 bzw. 810, 820, 830 oder 840 beim Überfahren einer Sensorfläche 355 keinen Tiefpunkt, da es zu keiner Verkleinerung der eingekoppelten Fläche der umliegenden Sensorflächen 355 kommt, und es kann ein hoher Rohwert mittels eines solchen invertierten Rotors 260 erhalten werden, wie er in Figur 4 gezeigt ist. Bei einem invertierten Rotor 260 sind verglichen mit einem herkömmlichen Rotor der Leiterabschnitt 462 bzw. die Kupferfläche und der Nichtleiterabschnitt 464 bzw. die Freifläche des Rotors 260 getauscht. Ein invertierter Rotor 260 zeichnet sich durch einen Leiterabschnitt 462 aus, der mehr als 180 Grad des Rotor 260 einnimmt. Bei einem invertierten Rotor 260 ist eine aktive Sensorfläche 355 nicht bedeckt und ist eine inaktive Sensorfläche 355 durch den Leiterabschnitt 462 bedeckt. Aus diesem Grund werden die Nutzsignale 286 bzw. 810, 820, 830 oder 840 rechnerisch invertiert.

Um Umwelteinflüsse und Störungen herauszurechnen und die Funktion nach einem Neustart des Sensorsystems 230 beizubehalten, wird die erste Messreihe als eine Referenzmessung durchgeführt. Dies wird durch eine Messung unter Konfiguration der umliegenden Sensorflächen 355 auf Shield durchgeführt. Dabei werden die umliegenden Sensoren 355 auf das Potenzial der zu messenden Sensorfläche 355 aufgeladen, somit ist über einen eingekoppelten und einen nicht-eingekoppelten Rotor 260 nahezu der gleiche Rohwert über alle Sensorflächen 355 zu messen. Die erste Messreihe dient als Referenz. Im Anschluss an die erste Messreihe bzw. Messung bei der Konfiguration der umliegenden Sensoren 355 auf Shield wird die zweite Messreihe mit der Konfiguration der umliegenden Sensorflächen 355 auf Ground durchgeführt. Die Differenz zwischen der Messung auf Ground zu der Messung auf Shield stellt das Nutzsignal 286 bzw. 810, 820, 830 oder 840 dar, wie es in Figur 8 gezeigt ist. Um die Nutzsignale 286 bzw. 810, 820, 830 und 840 untereinander vergleichen zu können, werden Verhältnisse der Nutzsignale 286 bzw. 810, 820, 830 und 840 untereinander aufgenommen und als Drehwinkelsensor-Parameter bezeichnet. Durch diese Verhältnisse werden die Nutzsignale 286 bzw. 810, 820, 830 und 840 untereinander prozentual angeglichen, wie es in Figur 9 gezeigt ist. Aufgrund des invertierten Rotors 260 werden die Nutzsignale 286 bzw. 810, 820, 830 und 840 invertiert und, um die Darstellbarkeit zu erhöhen, beispielsweise auf viele Werte, beispielhaft 1000 Werte, über das Verhältnis zwischen aktiven und inaktiven Sensorflächen 355 normiert, wie es in Figur 10 gezeigt ist.

Für die Drehpositionsbestimmung bzw. Winkelpositionsbestimmung werden die angeglichenen und invertierten Nutzsignale 286 bzw. 810, 820, 830 und 840 mittels der Gewichtungsberechnung auf eine definierte Auflösung umgerechnet. Für die Gewichtungsberechnung ist es beispielsweise erwünscht, dass Schnittpunkte zwischen steigenden und fallenden Nutzsignalen 286 bzw. 810, 820, 830 und 840 bei ca. 75 Prozent eines maximalen Signalwertes liegen. Aus diesem Grund sind die Sensorflächen 355 untereinander verzahnt, wie es in Figur 3 gezeigt ist, wodurch jede einzelne Sensorfläche 355 beim Überdrehen durch den Rotor 260 bereits früher überdeckt wird und somit der Schnittpunkt von fallenden und sinkenden Nutzsignalen 286 bzw. 810, 820, 830 und 840 erhöht wird.

Für eine genauere Positionsbestimmung werden Korridore innerhalb des gewichteten Wertes für eine Position festgelegt. Befindet sich der Wert eines Nutzsignals 286 bzw. 810, 820, 830 oder 840 innerhalb eines solchen Korridors, wird eine zugeordnete Raststellung des drehbaren Elements 120 erkannt. Befindet sich der Wert außerhalb des Korridors, wird die vorherige Position beibehalten. Dadurch wird das Springen zwischen zwei Positionen verhindert.

Anders ausgedrückt ist zur Drehpositionsermittlung die Kapazität jeder Sensorfläche 355 zu messen. Es kann zwischen zwei Extremfällen unterschieden werden, zum einen eine bedeckte, gescannte Sensorfläche 355 und zum anderen eine unbedeckte, gescannte Sensorfläche 355. Bei der bedeckten Sensorfläche 355 kann eine Potenzialdifferenz über den Rotor 260 eingekoppelt werden. Somit wird hier verglichen mit einer unbedeckten Sensorfläche 355 eine höhere Kapazität gemessen.

Damit das Bestimmungsverfahren 600 bzw. Messverfahren unabhängig von äußeren Störeinflüssen und absolut ist, wird die erste Messreihe bzw. eine Referenzmessung einer einzelnen Sensorfläche 355 bei Konfiguration umliegender Sensorflächen 355 auf Shield durchgeführt. Bei dieser Konfiguration ist eine geringe Kapazität zu messen, da alle Sensorflächen 355 auf dem gleichen Potenzial liegen und somit auch nicht über den Rotor 260 eingekoppelt werden können. Die Messung aller Sensorfläche 355 (egal ob bedeckt oder unbedeckt) kann somit zeitlich und zwischen den Sensorflächen 355 einen ähnlichen Messwert ergeben. Die erste Messreihe bzw. Referenzmessung wird mit jeder einzelnen Sensorfläche 355 des Stators 250 durchgeführt, bevor die zweite Messreihe bzw. eine weitere Messung ausgeführt wird. Die Messwerte werden beispielsweise in einem Array in einem Programm des Steuergerätes 270 gespeichert.

Trotz der Bemühung, die einzelnen Sensorflächen 355 möglichst gleich auszuführen, kann es zu Differenzen kommen, die sich auf die Nutzsignale 286 bzw. 810, 820, 830 und 840 der einzelnen Sensorflächen 355 auswirken können. Um die Nutzsignale 286 bzw. 810, 820, 830 und 840 trotzdem vergleichen zu können, sind Relativitäten aufgenommen worden. Dazu wurde beispielsweise ein Verhältnis eines maximalen Signalwerts einer Sensorfläche zu einem maximalen Signalwert eines Referenzsensors aufgenommen. Ein Referenzsensor kann jede der auf dem Stator 250 angeordneten Sensorflächen 355 sein. Mit diesen Relativitäten werden die Nutzsignale 286 bzw. 810, 820, 830 und 840 angeglichen.

Nach der ersten Messreihe bzw. der Referenzmessung werden alle Sensorflächen 355 erneut gescannt, dabei liegt das Potenzial der jeweils umliegenden Sensorflächen 355 einer gemessenen Sensorfläche 355 auf Ground. Bei der zweiten Messreihe wird bei einer bedeckten Sensorfläche 355 eine hohe Kapazität und bei einer unbedeckten Sensorfläche 355 eine geringe Kapazität gemessen. Die gemessene Kapazität wird beispielsweise in einem anderen Array in dem Programm des Steuergerätes 270 gespeichert.

Eine Differenz aus den Messreihen bzw. aus Referenz-Messung und Ground-Messung wird ermittelt, somit sind die einzelnen Sensorsignale untereinander vergleichbar. Außerdem werden Störeinflüsse (z. B. durch eine Hand) durch diese Berechnung eliminiert. Durch die tatsächlich durchgeführte Referenzmessung in der ersten Messreihe ist es auch ermöglicht, dass die Nutzsignale 286 bzw. 810, 820, 830 und 840 auch bei einem Neustart des Steuergerätes 270 vergleichbar mit vorherigen Werten bleiben.

Aufgrund der Verwendung des invertierten Rotors 260 werden die Nutzsignale 286 bzw. 810, 820, 830 und 840 der Sensorflächen 355 dann invertiert, um eine Gleichgewichtsberechnung durchführen zu können. Außerdem ist eine Signalhöhe jedes Nutzsignals 286 bzw. 810, 820, 830 und 840 nicht vollkommen identisch zu den anderen Sensoren, sodass ein weiteres Verhältnis aufgenommen wird, welches ein prozentuale Verhältnis zwischen einem Hochpunkt und einem Tiefpunkt eines Nutzsignals 286 bzw. 810, 820, 830 oder 840 beschreibt. Beide Vorgänge, Invertieren und Normieren, erfolgen beispielsweise in dem Schritt 640 des Verarbeitens. Normierte und invertierte Nutzsignale 286 bzw. 810, 820, 830 und 840 sind beispielsweise in Figur 10 dargestellt.

Im Vorfeld wird für das drehbare Element 120 bzw. den Drehwahlschalter eine Auflösung festgelegt. Aus den normierten und invertierten Nutzsignalen 286 bzw. 810, 820, 830 und 840 kann nun mit der Gewichtungsberechnung die Position bzw. Drehposition innerhalb der Auflösung ermittelt werden. Um die Auflösung zu definieren, wird im Vorfeld die Höhe der Nutzsignale 286 bzw. 810, 820, 830 und 840 betrachtet, außerdem kann ein Kreuzungspunkt zweier Signale bei ca. 75 Prozent des maximalen Signals liegen. Die Gewichtungsberechnung betrachtet die Sensorfläche 355 mit dem größten Signal. Da die Anordnung der Sensorflächen auf dem Stator 250 bekannt ist, kann über das höchste Signal der Nutzsignale 286 bzw. 810, 820, 830 und 840 bereits ein Korridor der Drehposition bestimmt werden. Über die benachbarten Sensorflächen 355 der Sensorfläche 355 mit dem höchsten Signal kann anschließend genauer auf die Drehposition geschlossen werden.

Die aus der Gleichgewichtungsberechnung berechnete Drehposition wird anschließend auf die gewünschte Anzahl von Positionen umgerechnet. Die gewünschte Anzahl von Positionen wird beispielsweise mittels eines Divisors und eines Modulo-Operators berechnet. Dafür wird zuvor ein Korridor bestimmt, in dem sich jede Drehposition oder Rastposition befindet. Die Verwendung eines Korridors hat den Vorteil, dass die Position sicher detektiert wird und nicht springt. Durch die Korridore ist es auch möglich zu erkennen, ob sich ein Rastwerk zwischen zwei Positionen befindet und somit festhängt. Eine Anzahl von Rastpositionen des drehbaren Elements 120 ist innerhalb der Auflösung innerhalb weiter Grenzen oder nahezu frei wählbar.

Die Position, Drehposition oder Rastposition des drehbaren Elements 120 bzw. Drehwahlschalters ist an dieser Stelle bekannt und kann von dem Steuergerät 270 bzw. weiterverarbeitet werden. Danach beginnt der Programmablauf zur kontaktlosen und absoluten Drehwinkelbestimmung auf kapazitiver Basis wieder von vorne mit der Durchführung der ersten Messreihe an den Sensorflächen 355, wie es beispielsweise in Figur 7 gezeigt ist.

Durch die Umrechnung der Auflösung auf Rastpositionen des drehbaren Elements 120 ist es zu jedem Zeitpunkt, beispielsweise während Entwicklung oder Fertigung oder nach Auslieferung, ferner möglich, eine Ausgangsrastposition frei auf dem drehbaren Element 120 bzw. Drehwahlschalter zu wählen.

Aus den Nutzsignalen 286 bzw. 810, 820, 830 und 840 bzw. umgerechneten Sensorsignalen kann über eine Gewichtungsberechnungsfunktion des Steuergerätes 270 beispielsweise ein sogenannter Radial Slider mit einer definierten Auflösung errechnet werden. Aus dieser Auflösung können die einzelnen Rastpositionen, die gewünscht sind, errechnet werden. In einem Bereich von lediglich beispielhaft 2 bis 13 Raststellungen ist dies mit den gegebenen Sensorflächen 355 möglich. Es ist dabei keine Hardware-Änderung notwendig, sondern lediglich eine Software-Anpassung. Vorteilhafterweise ist beispielsweise lediglich eine Sensorkonfiguration notwendig und in einem Fertigungsprozess braucht lediglich das passende Rastwerk montiert zu werden.

## Patentansprüche

1. Verfahren (600) zum Bestimmen einer Drehposition eines drehbaren Elements (120) für ein Haushaltgerät (100), das an dem Rotor (260) einer Vorrichtung (240) angeordnet ist, wobei die Vorrichtung (240) einen Stator (250) mit mehreren bezüglich einer Erstreckungsebene des Stators (250) voneinander getrennten kapazitiven Sensorflächen (355) und einen relativ zu dem Stator (250) drehbar angeordneten Rotor (260) mit einem elektrisch leitfähigen Leiterabschnitt (462) und einem dielektrischen Nichtleiterabschnitt (464) umfasst, wobei der Leiterabschnitt (462) ausgeformt ist, um mindestens zwei, bevorzugt mindestens drei Sensorflächen (355) des Stators (250) zu bedecken und wobei der Rotor (260) in einem relativ zu dem Stator (250) drehbar angeordneten Zustand gegenüberliegend der Erstreckungsebene des Stators (250) angeordnet ist,
wobei das Verfahren (600) folgende Schritte aufweist:
Durchführen (610) einer ersten Messreihe, bei der ein elektrisches Messpotenzial an alle Sensorflächen (355) des Stators (250) angelegt wird und ansprechend auf das Messpotenzial Referenzsignale (282) von den Sensorflächen (355) eingelesen werden, wobei die Referenzsignale (282) von einer Position des Rotors (260) abhängige erste Kapazitätswerte der Sensorflächen (355) repräsentieren;
Ausführen (620) einer zweiten Messreihe, bei der das elektrische Messpotenzial an eine zu messende Sensorfläche (355) der Sensorflächen (355) und ein elektrisches Massepotenzial an alle anderen Sensorflächen (355) angelegt werden, wobei in der zweiten Messreihe, bevorzugt sequenziell, jede Sensorfläche (355) als zu messende Sensorfläche (355) durchlaufen wird und ansprechend auf das Messpotenzial und das Massepotenzial Messsignale (284) von den Sensorflächen (355) eingelesen werden, wobei die Messsignale (284) von einer Position des Rotors (260) abhängige zweite Kapazitätswerte der Sensorflächen (355) repräsentieren;
Erzeugen (630) von Nutzsignalen (286; 810, 820, 830, 840) unter Verwendung der Referenzsignale (282) und der Messsignale (284); und
Verarbeiten (640) der Nutzsignale (286; 810, 820, 830, 840), um die Drehposition des drehbaren Elements (120) zu bestimmen.

2. Verfahren (600) gemäß Anspruch 1, bei dem im Schritt (630) des Erzeugens eine Differenz der Referenzsignale (282) und der Messsignale (284) gebildet wird, um die Nutzsignale (286; 810, 820, 830, 840) zu erzeugen.

3. Verfahren (600) gemäß einem der Ansprüche 1 bis 2, bei dem im Schritt (640) des Verarbeitens die Nutzsignale (286; 810, 820, 830, 840) unter Verwendung zumindest eines Verhältnisses zwischen einem Hochpunkt und einem Tiefpunkt eines Nutzsignals (286; 810, 820, 830, 840) aneinander angeglichen werden.

4. Verfahren (600) gemäß einem der Ansprüche 1 bis 3, bei dem im Schritt (640) des Verarbeitens die Nutzsignale (286; 810, 820, 830, 840) normiert und/oder invertiert werden.

5. Verfahren (600) gemäß einem der Ansprüche 1 bis 4, bei dem im Schritt (640) des Verarbeitens eine Gewichtungsberechnung an den Nutzsignalen (286; 810, 820, 830, 840) durchgeführt wird.

6. Verfahren (600) gemäß Anspruch 5, bei dem das Nutzsignal (286; 810, 820, 830, 840) mit dem größten Signalwert als Bezugssignal für die Gewichtungsberechnung berücksichtigt wird, wobei unter Verwendung einer Position der dem Bezugssignal zugeordneten Sensorfläche (355) ein Korridor für die Drehposition des drehbaren Elements (120) ermittelt wird, wobei unter Verwendung von Nutzsignalen (286; 810, 820, 830, 840) von zu der dem Bezugssignal zugeordneten Sensorfläche (355) benachbarten Sensorflächen (355) die Drehposition des drehbaren Elements (120) innerhalb des ermittelten Korridors bestimmt wird.

7. Verfahren (600) gemäß einem der Ansprüche 1 bis 6, wobei das Verfahren (600) weiter folgende Schritte aufweist:
Wiederholen der Schritte des Ausführens (620) einer zweiten Messreihe, des Erzeugens (630) von Nutzsignalen (286; 810, 820, 830, 840) und des Verarbeitens (640) der Nutzsignale (286; 810, 820, 830, 840), wobei in dem Schritt des Ausführens (620) der zweiten Messreihe von nur einigen, bevorzugt nur einer der Sensorflächen (355) Messsignale (284) eingelesen werden.

8. Sensorsystem (230) zum Ermitteln einer Drehposition eines drehbaren Elements (120), wobei das Sensorsystem (230) folgende Merkmale aufweist:
eine Vorrichtung (240), die einen Stator (250) mit mehreren bezüglich einer Erstreckungsebene des Stators (250) voneinander getrennten kapazitiven Sensorflächen (355) und einen relativ zu dem Stator (250) drehbar angeordneten Rotor (260) mit einem elektrisch leitfähigen Leiterabschnitt (462) und einem dielektrischen Nichtleiterabschnitt (464) umfasst, wobei der Leiterabschnitt (462) ausgeformt ist, um mindestens zwei, bevorzugt mindestens drei Sensorflächen (355) des Stators (250) zu bedecken, wobei der Leiterabschnitt (462) bevorzugt flächenmäßig größer als der Nichtleiterabschnitt (464) ist, und wobei der Rotor (260) in einem relativ zu dem Stator (250) drehbar angeordneten Zustand gegenüberliegend der Erstreckungsebene des Stators (250) angeordnet ist; und
ein Steuergerät (270), wobei das Steuergerät (270) signalübertragungsfähig mit den Sensorflächen (355) des Stators (250) der Vorrichtung (240) verbindbar oder verbunden ist.

9. Haushaltgerät (100), das folgende Merkmale aufweist:
eine Bedieneinrichtung (110) mit einem drehbaren Element (120), einer Bedienseite und einer von der Bedienseite abgewandten Geräteseite, wobei das drehbare Element (120) auf der Bedienseite angeordnet ist; und
das Sensorsystem (230) gemäß Anspruch 9, wobei der Rotor (260) der Vorrichtung (240) des Sensorsystems (230) mit dem drehbaren Element (120) der Bedieneinrichtung (110) gekoppelt und der Stator (250) der Vorrichtung (240) des Sensorsystems (230) auf der Geräteseite der Bedieneinrichtung (110) angeordnet ist.

10. Haushaltgerät (100) gemäß Anspruch 10, bei dem die Bedieneinrichtung (110) einen durchgehend ausgeformten dielektrischen Gehäuseabschnitt aufweist, wobei zumindest die Vorrichtung (240) des Sensorsystems (230) und das drehbare Element (120) an dem Gehäuseabschnitt angeordnet sind.

11. Computer-Programmprodukt mit Programmcode zur Durchführung des Verfahrens (600) nach einem der Ansprüche 1 bis 7, wenn das Computer-Programmprodukt auf dem Steuergerät (270) des Sensorsystems nach Anspruch 8 ausgeführt wird.

## Claims

1. Method (600) for determining a rotational position of a rotatable element (120) for a household appliance (100), which element is arranged on the rotor (260) of a device (240), wherein the device (240) comprises a stator (250) having a plurality of capacitive sensor surfaces (355) separated from one another with respect to an extension plane of the stator (250) and comprises a rotor (260) which is arranged so as to be rotatable relative to the stator (250) and has an electrically conductive conductor portion (462) and a dielectric non-conductor portion (464), wherein the conductor portion (462) is shaped in order to cover at least two, preferably at least three, sensor surfaces (355) of the stator (250) and wherein the rotor (260) is arranged opposite the extension plane of the stator (250) when in a state in which it is arranged so as to be rotatable relative to the stator (250), wherein the method (600) comprises the following steps:
carrying out (610) a first measurement series in which an electrical measurement potential is applied to all sensor surfaces (355) of the stator (250) and reference signals (282) are read in from the sensor surfaces (355) in response to the measurement potential, wherein the reference signals (282) represent first capacitance values of the sensor surfaces (355) that are dependent on a position of the rotor (260);
executing (620) a second measurement series in which the electrical measurement potential is applied to one sensor surface (355) of the sensor surfaces (355) that is to be measured and an electrical ground potential is applied to all the other sensor surfaces (355), wherein, in the second measurement series, each sensor surface (355) is traversed, preferably sequentially, as a sensor surface (355) to be measured and measurement signals (284) are read in from the sensor surfaces (355) in response to the measurement potential and the ground potential, wherein the measurement signals (284) represent second capacitance values of the sensor surfaces (355) that are dependent on a position of the rotor (260);
generating (630) useful signals (286; 810, 820, 830, 840) using the reference signals (282) and the measurement signals (284); and
processing (640) the useful signals (286; 810, 820, 830, 840) in order to determine the rotational position of the rotatable element (120).

2. Method (600) according to claim 1, in which, in the generating step (630), a difference of the reference signals (282) and the measurement signals (284) is formed in order to generate the useful signals (286; 810, 820, 830, 840).

3. Method (600) according to either claim 1 or claim 2, in which, in the processing step (640), the useful signals (286; 810, 820, 830, 840) are equalised using at least one ratio between a high point and a low point of a useful signal (286; 810, 820, 830, 840).

4. Method (600) according to any of claims 1 to 3, in which, in the processing step (640), the useful signals (286; 810, 820, 830, 840) are normalised and/or inverted.

5. Method (600) according to any of claims 1 to 4, in which, in the processing step (640), a weighting calculation is performed on the useful signals (286; 810, 820, 830, 840).

6. Method (600) according to claim 5, in which the useful signal (286; 810, 820, 830, 840) having the largest signal value is taken into account as a reference signal for the weighting calculation, wherein, using a position of the sensor surface (355) associated with the reference signal, a corridor is detected for the rotational position of the rotatable element (120), wherein, using useful signals (286; 810, 820, 830, 840) of sensor surfaces (355) adjacent to the sensor surface (355) associated with the reference signal, the rotational position of the rotatable element (120) is determined within the detected corridor.

7. Method (600) according to any of claims 1 to 6, wherein the method (600) further comprises the following steps:
repeating the steps of executing (620) a second measurement series, generating (630) useful signals (286; 810, 820, 830, 840) and processing (640) the useful signals (286; 810, 820, 830, 840), wherein, in the step of executing (620) the second measurement series, measurement signals (284) are read in from only a few, preferably only one, of the sensor surfaces (355).

8. Sensor system (230) for determining a rotational position of a rotatable element (120), wherein the sensor system (230) has the following features:
a device (240) which comprises a stator (250) having a plurality of capacitive sensor surfaces (355) separated from one another with respect to an extension plane of the stator (250) and comprises a rotor (260) which is arranged so as be rotatable relative to the stator (250) and has an electrically conductive conductor portion (462) and a dielectric non-conductor portion (464), wherein the conductor portion (462) is shaped in order to cover at least two, preferably at least three, sensor surfaces (355) of the stator (250), wherein the conductor portion (462) is preferably larger in terms of surface area than the non-conductor portion (464), and wherein the rotor (260) is arranged opposite the extension plane of the stator (250) when in a state in which it is arranged so as to be rotatable relative to the stator (250); and
a control unit (270), wherein the control unit (270) is or can be connected to the sensor surfaces (355) of the stator (250) of the device (240) so as to be capable of transmitting signals.

9. Household appliance (100) which has the following features:
an operating apparatus (110) having a rotatable element (120), an operating side and an appliance side facing away from the operating side, wherein the rotatable element (120) is arranged on the operating side; and
the sensor system (230) according to claim 9, wherein the rotor (260) of the device (240) of the sensor system (230) is coupled to the rotatable element (120) of the operating apparatus (110), and the stator (250) of the device (240) of the sensor system (230) is arranged on the appliance side of the operating apparatus (110).

10. Household appliance (100) according to claim 10, in which the operating apparatus (110) has a continuous dielectric housing portion, wherein at least the device (240) of the sensor system (230) and the rotatable element (120) are arranged on the housing portion.

11. Computer program product comprising program code for carrying out the method (600) according to any of claims 1 to 7 when the computer program product is executed on the control unit (270) of the sensor system according to claim 8.

## Revendications

1. Procédé (600) de détermination d'une position de rotation d'un élément rotatif (120) d'un appareil ménager (100) disposé sur le rotor (260) d'un dispositif (240), le dispositif (240) comprenant un stator (250) comportant une pluralité de surfaces de capteurs capacitifs (355) séparées les unes des autres par rapport à un plan d'extension du stator (250), et un rotor (260) disposé en rotation par rapport au stator (250) comportant une section conductrice électroconductrice (462) et une section non conductrice diélectrique (464), la section conductrice (462) étant formée pour recouvrir au moins deux, de préférence au moins trois surfaces de capteur (355) du stator (250), et le rotor (260) dans un état disposé en rotation par rapport au stator (250) étant disposé en face du plan d'extension du stator (250), le procédé (600) comprenant les étapes :
de réalisation (610) d'une première série de mesures, un potentiel de mesure électrique étant appliqué à toutes les surfaces de capteur (355) du stator (250) et des signaux de référence (282) étant lus à partir des surfaces de capteur (355) en réponse au potentiel de mesure, les signaux de référence (282) représentant de premières valeurs de capacité des surfaces de capteur (355) qui sont dépendantes d'une position du rotor (260) ;
d'exécution (620) d'une seconde série de mesures, le potentiel de mesure électrique étant appliqué à une surface de capteur (355) à mesurer des surfaces de capteur (355) et un potentiel de masse électrique étant appliqué à toutes les autres surfaces de capteur (355), dans la seconde série de mesures, de préférence séquentiellement, chaque surface de capteur (355) étant traversée comme surface de capteur (355) à mesurer et des signaux de mesure (284) étant lus à partir des surfaces de capteur (355) en réponse au potentiel de mesure et au potentiel de masse, les signaux de mesure (284) représentant de secondes valeurs de capacité des surfaces de capteur (355) qui sont dépendantes d'une position du rotor (260) ;
de production (630) des signaux utiles (286 ; 810, 820, 830, 840) à l'aide des signaux de référence (282) et des signaux de mesure (284) ; et
de traitement (640) des signaux utiles (286 ; 810, 820, 830, 840) pour déterminer la position de rotation de l'élément rotatif (120).

2. Procédé (600) selon la revendication 1, dans lequel, à l'étape (630) de production, une différence est formée entre les signaux de référence (282) et les signaux de mesure (284) pour produire les signaux utiles (286 ; 810, 820, 830, 840).

3. Procédé (600) selon l'une des revendications 1 à 2, dans lequel, à l'étape (640) de traitement, les signaux utiles (286 ; 810, 820, 830, 840) sont égalisés à l'aide d'au moins un rapport entre un point haut et un point bas d'un signal utile (286 ; 810, 820, 830, 840).

4. Procédé (600) selon l'une des revendications 1 à 3, dans lequel, à l'étape (640) de traitement, les signaux utiles (286 ; 810, 820, 830, 840) sont normalisés et/ou inversés.

5. Procédé (600) selon l'une des revendications 1 à 4, dans lequel, à l'étape (640) de traitement, un calcul de pondération est effectué sur les signaux utiles (286 ; 810, 820, 830, 840).

6. Procédé (600) selon la revendication 5, dans lequel le signal utile (286 ; 810, 820, 830, 840) ayant la plus grande valeur de signal est considéré comme signal de référence pour le calcul de pondération, un corridor pour la position de rotation de l'élément rotatif (120) étant déterminé à l'aide d'une position de la surface de capteur (355) associée au signal de référence et la position de rotation de l'élément rotatif (120) étant déterminée dans le corridor déterminé à l'aide des signaux utiles (286 ; 810, 820, 830, 840) des surfaces de capteur (355) adjacentes à la surface de capteur (355) associée au signal de référence.

7. Procédé (600) selon l'une des revendications 1 à 6, le procédé (600) comprenant en outre les étapes :
de répétition des étapes d'exécution (620) d'une seconde série de mesures, de production (630) des signaux utiles (286 ; 810, 820, 830, 840) et de traitement (640) des signaux utiles (286 ; 810, 820, 830, 840), à l'étape d'exécution (620) de la seconde série de mesures, les signaux de mesure (284) ne sont lus que par certaines, de préférence par une seule des surfaces de capteur (355).

8. Système de capteur (230) destiné à déterminer une position de rotation d'un élément rotatif (120), le système de capteur (230) présentant les caractéristiques suivantes :
un dispositif (240) comprenant un stator (250) comportant une pluralité de surfaces de capteurs capacitifs (355) séparées les unes des autres par rapport à un plan d'extension du stator (250), et un rotor (260) disposé en rotation par rapport au stator (250) et comportant une section conductrice électroconductrice (462) et une section non-conductrice diélectrique (464), la section conductrice (462) étant formée, pour recouvrir au moins deux, de préférence au moins trois surfaces de capteur (355) du stator (250), la section conductrice (462) présentant de préférence une surface plus grande que celle de la section non conductrice (464), et le rotor (260) dans un état disposé en rotation par rapport au stator (250) étant disposé en face du plan d'extension du stator (250) ; et
une unité de commande (270), l'unité de commande (270) pouvant être reliée ou étant reliée de manière à pouvoir transmettre des signaux aux surfaces de capteur (355) du stator (250) du dispositif (240).

9. Appareil ménager (100) présentant les caractéristiques suivantes :
un dispositif de commande (110) comportant un élément rotatif (120), un côté de commande et un côté de l'appareil opposé au côté de commande, l'élément rotatif (120) étant disposé sur le côté de commande ; et
le système de capteur (230) selon la revendication 9 le rotor (260) du dispositif (240) du système de capteur (230) étant accouplé à l'élément rotatif (120) du dispositif de commande (110), et le stator (250) du dispositif (240) du système de capteur (230) étant disposé du côté de l'appareil du dispositif de commande (110).

10. Appareil ménager (100) selon la revendication 10, dans lequel le dispositif de commande (110) comporte une section de boîtier diélectrique formée en continu, dans lequel au moins le dispositif (240) du système de capteur (230) et l'élément rotatif (120) sont disposés sur la section de boîtier.

11. Produit de programme informatique comportant un code de programme destiné à exécuter le procédé (600) selon l'une des revendications 1 à 7 lorsque le produit de programme informatique est exécuté sur l'unité de commande (270) du système de capteur selon la revendication 8.
